**Europäisches Patentamt**

(19) **European Patent Office** (11) Publication number: **0 081 389**

**Office européen des brevets** **B1**

(12) **EUROPEAN PATENT SPECIFICATION**

(45) Date of publication of patent specification: **03.09.86** (51) Int. Cl.⁴: **H 01 R 4/02,** H 01 R 4/70

(21) Application number: **82306555.2**

(22) Date of filing: **08.12.82**

(54) **Device for connecting electrical conductors.**

(30) Priority: **08.12.81 US 328761**
**08.12.81 US 328762**

(43) Date of publication of application:
**15.06.83 Bulletin 83/24**

(45) Publication of the grant of the patent:
**03.09.86 Bulletin 86/36**

(84) Designated Contracting States:
**AT BE CH DE FR IT LI NL SE**

(56) References cited:
**US-A-3 396 894**
**US-A-3 719 981**
**US-A-4 099 038**

(73) Proprietor: **RAYCHEM CORPORATION**
**300 Constitution Drive**
**Menlo Park California 94025 (US)**

(72) Inventor: **Allen, Leslie John**
**The Warren Knightscott Road**
**Sandylane, Abbotsleigh Bristol (GB)**
Inventor: **Graussauer, Wille Karl**
**723 Marsh Road No. 10**
**Menlo Park California 94025 (US)**
Inventor: **Robinson, William Morris**
**4164 Wilkie Way**
**Palo Alto California 94306 (US)**

(74) Representative: **Jones, David Colin et al**
**Raychem Limited Intellectual Property Law**
**Department Swan House 37-39 High Holborn**
**London WC1 (GB)**

Courier Press, Leamington Spa, England.

## Description

This invention relates to devices for connecting electrical conductors, and especially for terminating a plurality of closely spaced conductors to a connector or other substrate.

Joining flat cable or ribbon cable to connectors can be accomplished by a number of different methods, with soldering being probably the most reliable. However, if all the solder terminations must be done by hand, the costs involved and the time required to perform a multiplicity of repetitive soldering operations far outweigh any gains in reliability. In addition, as connector pin spacing decreases, due to higher interconnection densities, the reliability of hand soldering decreases because of the possibility of solder bridging terminations and shorting out adjacent connectors. It would therefore be desirable to have a solder system in which all leads can be soldered to the connector simultaneously, rapidly and reliably for a wide range of a number of terminations and spacings.

In the past, various systems have been developed for simultaneously applying a plurality of bodies of solder. One such system is that disclosed in U.S. Patent number 3,396,894, which discloses the pre-packaging of metered amounts of flux and solder in a heat-recoverable preformed polymer sheet which forces the solder into place. The patent teaches the use of discrete pieces of solder which must be precisely positioned above regions to be soldered. As heat is applied, the polymer sheet returns to its original flat configuration prior to solder melting.

U.S. Patent 3,719,981 discloses an alternative method of applying solder balls, which are appropriately spaced on the tacky surface of a pressure-sensitive tape, to solder bumps used for connections.

Both of the above methods rely on the positioning of the small pieces of solder immediately adjacent to the terminals which are to be soldered, and, because small pieces of solder are used, each of the solder systems disclosed is difficult to manufacture.

U.S. Patent No. 4,099,038 describes a flat cable assembly wherein an end portion of a first flat cable is overlapped and bonded to an end portion of a second flat cable, the conductors in the first cable being aligned above the conductors in the second cable. A plurality of holes is provided in the insulating material in the overlapped region between the two sets of conductors, each hole being provided with a quantity of solder to connect the conductors from the first set to the conductors of the second set.

U.S. Patent number 3,750,252 discloses the use of a single continuous piece of solder to simultaneously solder a large number of terminals. The solder wire extends along a terminal strip and, on heating, the solder melts and coalesces on the individual contacts to form independent connections.

European Patent Publication No. 0,041,857, which forms part of the state of the art under EPC Article 54(3), discloses a solder delivery system for terminating a plurality of conductors to a connector, and comprises two polymeric layers with a strip of solder sandwiched between the layers, and at least one of the layers containing a plurality of conductors. In use the conductors are placed on corresponding terminals on the connector and the delivery means is then placed in contact with the conductors with the side containing the windows positioned towards the conductors and connector.

With the increasing use of ribbon or "flexprint" cable, especially multilayer cable, which is analogous to flexible printed circuit board, and the decreasing size of many electronic assemblies, so that bulky connectors are disadvantageous, a method of terminating flat cables to flat substrates has also become extremely desirable.

According to one aspect, the present invention provides a device for electrically connecting at least one first conductor to at least one second conductor, which comprises a dimensionally heat stable polymeric layer having at least one window therein, one or more strips of fusible electrically conductive material disposed with respect to the window or windows to allow the conductive material to flow through the or each window and to form a conductive connection between conductors positioned on opposite sides of the polymeric layer, and, in addition to the window or windows, one or more hollow positioning elements defined at least partly by the polymeric layer capable of receiving the or each first conductor and retaining the or each first conductor in position in the device.

According to another aspect, the invention provides a device for electrically connecting at least one first conductor to at least one second conductor, which comprises a dimensionally heat stable polymeric layer having at least one window therein, at least one strip of fusible electrically conductive material disposed with respect to the window or windows to allow the conductive material to flow through the or each window to form a conductive connection between conductors positioned on opposite sides of the polymeric layer, the window or windows forming one or more hollow positioning elements, the or each window being shaped to provide a portion capable of gripping a first conductor, to receive and retain the or each first conductor in the device.

It is preferred that the device according to either aspect of the invention is for electrically connecting electrical conductors of a set of first conductors to electrical conductors of a set of second conductors.

Preferably the device includes a further polymeric layer that is bonded to the heat-stable polymeric layer to form at least one pocket which contains the or at least one of the windows and which constitutes a hollow positioning element. This form of the device has the advantage that the further polymeric layer may be employed to insulate the connection and to strain relieve the first conductors. This is especially true if, as is preferred, the said further polymeric layer is dimensionally heat-recoverable so as to grip the or each first conductor when heated. In addition, the use of a heat-recoverable layer has the advantage that the pockets may be made sufficiently large to facilitate insertion of the conductors therein without loss of alignment.

The fusible, electrically conductive material used to form the strip may be formed from any of a number of materials, e.g. fusible plastics materials that have a high loading of a metal filler in the form of particles or flake. Preferably, however the fusible, conductive material comprises solder. As used herein, solder means any metal or metallic alloy used to join metallic surfaces by melting that metal or metallic alloy and then allowing it to cool. A solder strip, as used herein, means an elongated, continuous element of solder of any cross-section including, but not limited to, round, square, flat, or any other cross-section. Such a solder strip may contain a flux core and/or may be coated on all or a part of its outer surface with a flux coating. The strip may be perforated to enable better flow of a flux core.

The polymeric layers should preferably be made of materials capable of resisting elevated temperatures for the time needed to melt and flow the solder, generally about 15 seconds. Suitable materials include, for example and not by way of limitation, polyvinylidene fluoride, poly-(parabanic acid), and poly(pyromelittimide) or other high-temperature polyamides or -imides. These polymers may be cross-linked by either chemicals or radiation to improve their high-temperature properties.

Lower-temperature polymers, such as polyethylene, etc., may be used depending on the particular use to which the terminator is to be put, and the choice of suitable materials is considered to be within the scope of one skilled in the art in view of this disclosure.

While the provision of adhesive and sealant layers is contemplated by this invention, and will be discussed in more detail below with respect to certain preferred areas, it is also contemplated that the polymeric layers may themselves have adhesive properties, even though they are generally required to be non-melting in use. Such properties may be particularly desirable for the window layer, and may be provided, for example, by extensive cross-linking of an adhesive material. By this means, the device may be adhered to a substrate in use.

While the window layer is heat-stable, the further polymeric layer which forms the pockets is, as stated above, preferably heat recoverable. Heat recoverable polymers and methods of rendering polymeric articles heat recoverable, are well known in the art. These are generally cross-linked, at least partially crystalline polymers, or mixtures incorporating them.

The polymeric materials can be tailored to suit the intended use by the addition of fillers, e.g. flame-retardants, plasticizers, pigments, stabilizers, co-curing agents to facilitate cross-linking, etc.

The polymeric materials used in the construction of this invention are important in the transfer of thermal energy. While the primary heat transfer occurs through the metallic elements, including the conductors, terminals, and solder, a significant amount of heat is transferred through the window in a parallel manner. Additionally, the flux trapped within the window spaces is a significant source of circulatory liquid and vapor mass heat transfer. The presence of these additional heat transfer paths contributes to the overall speed and quality of the desired solder connections.

An advantage of the terminator of this invention is that it readily permits "tapping" a flat cable or similar substrate at a plurality of points. The insulation may be stripped from one side only of the cable, and a terminator according to this invention used to make connections between the thus-exposed conductors of the cable and other conductors. While the terminator would normally be placed parallel to the cable, if a stair-step configuration of the windows is used, it may be placed perpendicular to the cable to allow an extremely convenient "tap".

According to another aspect, the invention provides a method of electrically connecting at least one first conductor to at least one second conductor by means of a device comprising a dimensionally heat-stable polymeric layer having at least one window therein and at least one strip of fusible electrically conductive material disposed with respect to the window or windows to allow the conductive material to flow through the or each window when heated, the device including one or more hollow positioning elements defined at least partly by the polymeric layer for receiving the or each first conductor and retaining the or each first conductor in position in the device, which method comprises positioning the or each first conductor on one side of the heat-stable polymeric layer so that the or each first conductor is received by a positioning element, positioning the or each second conductor on the opposite side of the heat-stable polymeric layer so that at least one first conductor and at least one second conductor are in register with at least one window, and heating the device to melt the electrically conductive material so that the electrically conductive material forms a conductive connection between the first and second conductor.

Several forms of device according to the invention and their use will now be described by way of example with reference to the accompanying drawings in which:

Figure 1 is a cross-sectional view of a first embodiment of this invention used to terminate a wire to a flat substrate.

Figure 2 is a cross-section through line 2—2 and Figure 3 a cross-section through line 3—3 of Figure 1.

Figure 4 is a perspective view of a second embodiment of this invention used to terminate twisted pairs.

Figure 5 is a view of this second embodiment from beneath, while Figures 6 and 7 are cross-sections through lines 6—6 and 7—7, respectively, of Figure 5.

Figure 8 is a perspective view of a heater platen for use with the embodiment of Figure 4.

Figure 9 is a perspective view of a third embodiment designed for terminating triaxial cable.

Figure 10 is a cross-section through line 10—10 of Figure 9, also showing an inserted triaxial cable.

Figure 11 is similar to Figure 10 but shows an alternative method of positioning the center conductor, while Figure 12 is an underneath view of the embodiment of Figure 11.

Figures 13 and 14 depict the operation of the polymer layers and the solder during termination.

Figures 15 and 16 depict a method of connection according to the invention.

Figure 17 depicts yet another method in which the backing layer has holes through which the conductors may protrude, and Figure 18 depicts that embodiment with a cable ready for soldering.

Figure 19 depicts the use of windows shaped to retain the conductors of a cable, while Figure 20 is a side view of Figure 19.

Figures 21 and 22 depict a device for use in another method; and

Figures 23 and 24 show another form of device.

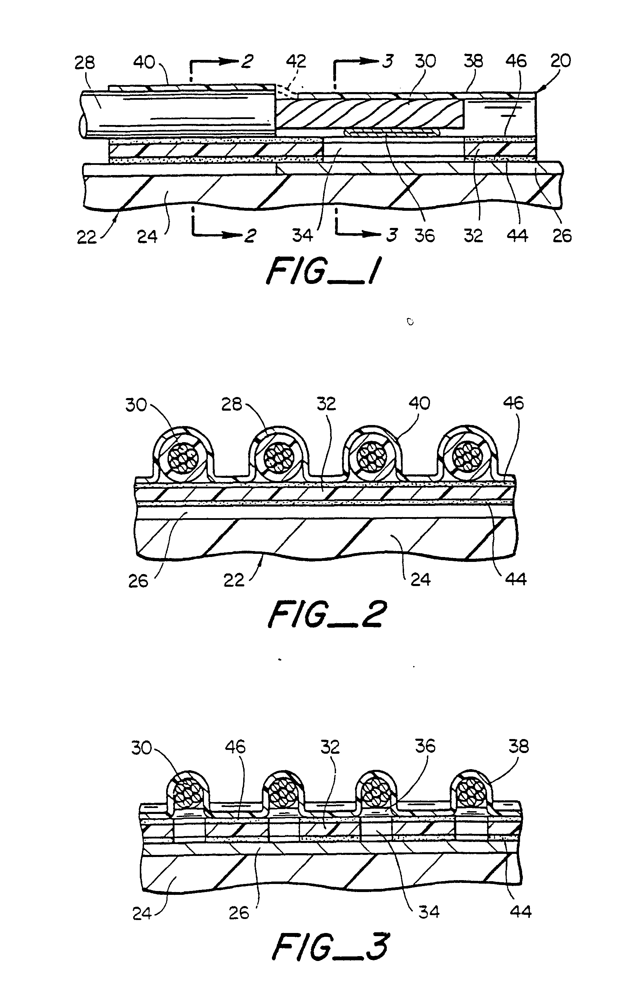

Figure 1 is a cross-sectional view through a pocket of a first embodiment of this invention where the terminator shown generally at 20 is being used to terminate a conductor to a flat substrate, such as a printed circuit board shown generally at 22 and comprising an insulating support 24 and conductive region 26. The wire 28 having first conductor 30 has been inserted into terminator 20. The terminator comprises a first polymeric layer 32 having a window 34 therein (the window layer), a solder strip 36 positioned adjacent the window 34, and a polymeric backing layer which is shown here as two regions 38, over the conductors 30, and 40, over the insulation of wire 28. If these regions were joined by the region 42 shown in phantom, a unitary backing layer would be formed. This backing layer is heat recoverable. The window layer is adhered to the substrate 22 by adhesive layer 44 and to the backing layer by adhesive layer 46. Alternatively, the window layer may be itself adhesive and/or be fusion bonded or otherwise attached to the backing layer.

When the conductor is inserted so that it overlays the window 34 and heat and pressure are applied, solder 36 fuses to form an electrical connection between the first conductor 30 and conductive region or second conductor 26 through the window 36, and the backing layer recovers (shrinks) to encapsulate the wire, thereby insulating and strain-relieving the connection thus formed.

Figure 2 is a cross-section through line 2—2 of Figure 1 illustrating the wire 28 in the pocket formed between layers 32 and 40, while Figure 3, which is a cross-section through line 3—3 of Figure 1, illustrates the conductor in position above the solder 36 and windows 34.

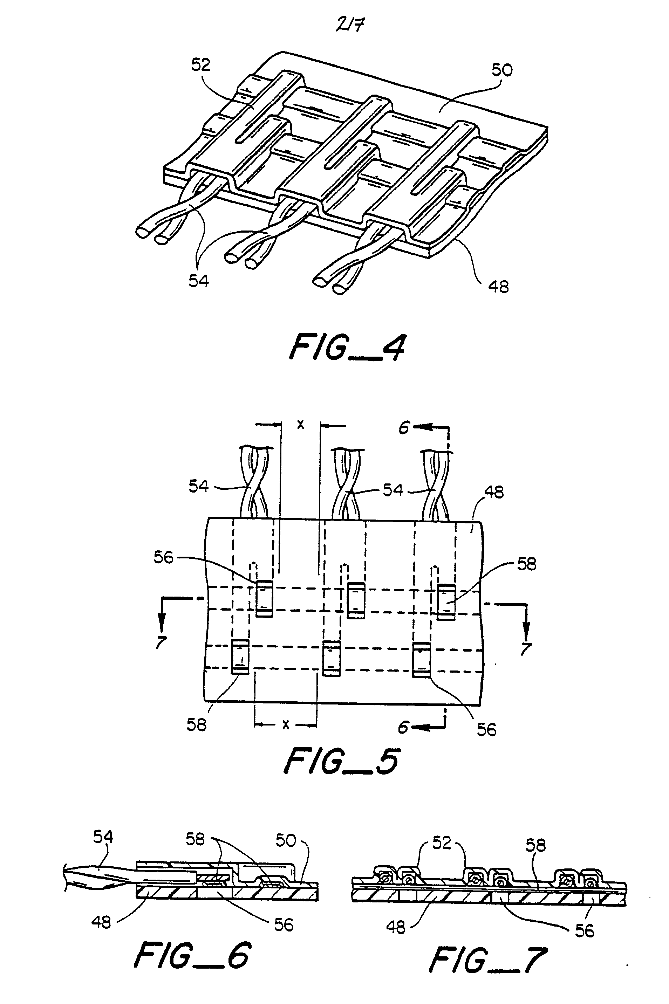

Figure 4 depicts in perspective a second embodiment useful for the termination of twisted pair wires. The terminator comprises a window layer 48 and backing layer 50 bonded together appropriately, with pockets 52 formed in backing layer 50. Wires 54 are shown inserted into the pockets, which are shaped such that the ends of wires 54, cut and stripped to different lengths, enter separate sub-pockets for termination. These sub-pockets end above two rows of windows 56 as shown in Figure 5, which is a bottom view of the terminator of Figure 4. Window layer 48 has two rows of windows 56, with a solder strip 58 shown mostly in phantom, between layers 48 and 50 and adjacent each window.

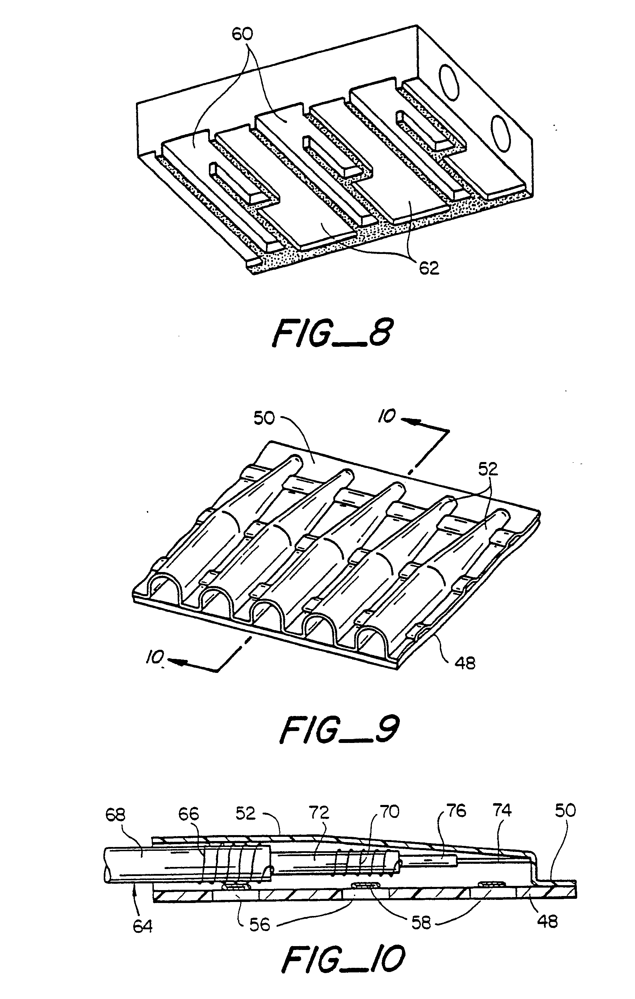

Figure 6 is a cross-section through line 6—6 of Figure 5, and depicts one of the pair 54, in a manner similar to Figure 1. Figure 7 is a cross-section through line 7—7 of Figure 5, and shows one row of windows 56, with the corresponding solder strip 58 and the pair of sub-pockets of pocket 52.

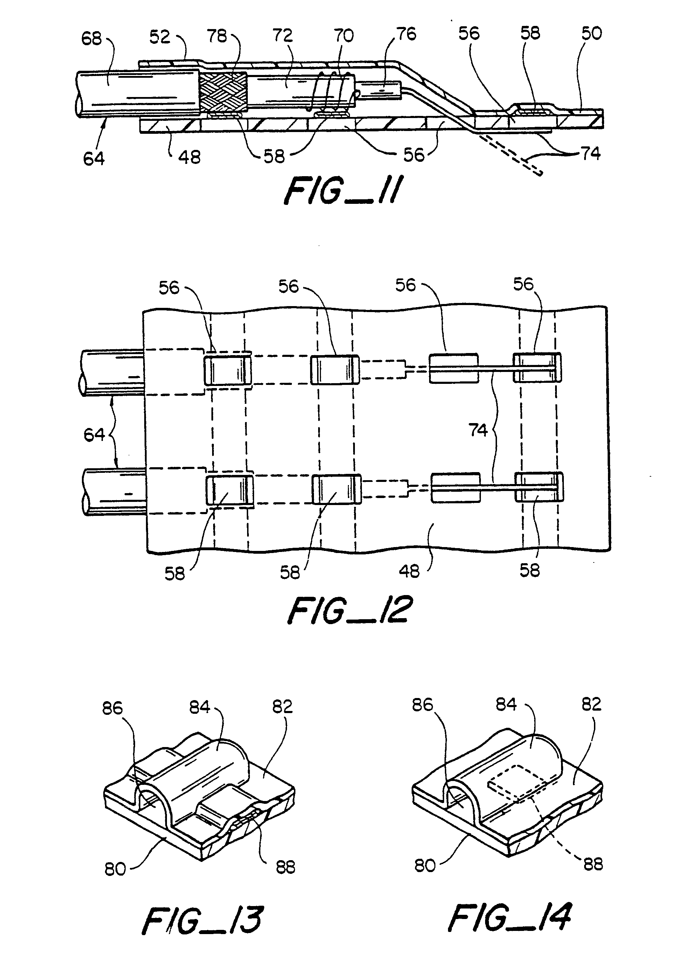

Soldering the wires through the windows is accomplished by application of heat and pressure, which will also cause the pad to become properly heated for effective soldering. The spaces along the solder strips whose length is indicated by "x" in Figure 5 may be left unheated, and will then remain unmelted and free from contact with anything but the polymer layers surrounding them. The solder in and around the window will have been heated and propelled into the window by force from a heating tool, which is shown in Figure 8 in perspective view from underneath. In Figure 8, the shaded region is in the plane of the window layers, causing the heating and separation of the solder, while relief area 60 defines a cavity for the wires in the pockets. Relief area 62, if present, allows for the unmelted solder regions discussed above, but if that relief is absent, all the solder would be forced from between the wire cavities into the window areas. A smaller center-to-center spacing or alternative tool design could produce the same effect.

Some variations can be made in the invention to accommodate the general physical characteristics of coaxial, triaxial or other multiaxial wire cables. Most have a centrally located center wire surrounded with a thick wall insulation to provide a large dimensional separation from the next coaxial wire. This next wire is also wrapped with a thin electrically conductive foil to create a shield.

Sometimes this second wire is replaced entirely by a multitude of smaller, braided wires forming a net like shield. This can be followed by a third wire, braid, etc., to provide additional electrical and/or mechanical shielding.

Thus there are two or more electrical connections to make per multiaxial cable. In addition the geometric dimension considerations present unusual problems when it is desired to electrically and mechanically join these cables to flat surfaces. The following variation of the invention as shown in Figures 9 through 12 will illustrate its usefulness.

Figure 9 is a top perspective view of a terminator designed for coaxial wire. The window layer 48 and backing layer 50 form pockets 52.

Figure 10 is a cross-section through one pocket of the embodiment of Figure 9, with a triaxial cable 64 inserted in pocket 50. Here, each of the three conductors to be terminated, outer conductor 66 (which has been wound back over insulation 68), middle conductor 70 (which has been wound back over insulation 72), and center conductor 74 (protruding from insulation 76), are shown emplaced above solder strips 58 and windows 56 formed in window layer 48. Termination is again accomplished by heat and pressure, using an appropriately-shaped heating tool.

Figure 11 is a view similar to Figure 10 except that 4 windows are present per pocket. Three of the windows are used in controlling the placement of solder and the formation of inter connections between the conductors and substrates, while the fourth permits the passage of a center conductor 74. In this way, the thin center conductor 74 is brought into direct contact with the substrate when the terminator is in place, helping to ensure a good solder joint. In this figure, also, the outer conductor has been shown as a braid 78, as is common with multiaxial wire.

Figure 12 is a bottom view of the embodiment of Figure 11, when the center conductor 74 can be clearly seen below the window layer 48.

This system is of course applicable to coaxial cables, where one less window and solder strip is required.

Strain and relief for the connection formed is provided by recovery of pocket 52 about the wire 64 while either polymeric layer may have adhesive associated therewith, as discussed elsewhere.

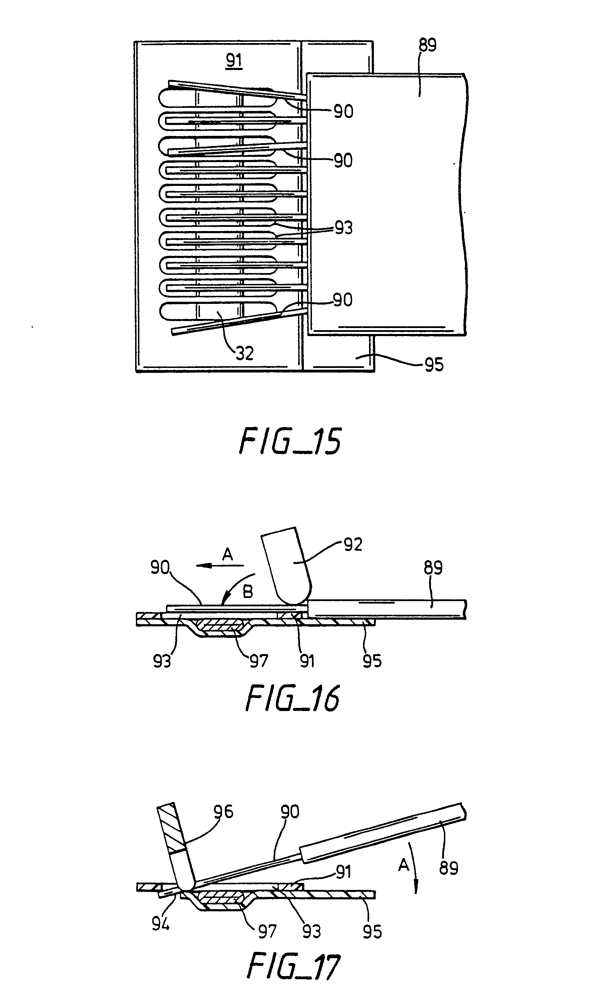

Figures 13 and 14, which show a single pocket and solder strip for simplicity, clarify the operation of the invention. Window layer 80 and backing layer 82, with pocket 84 therein, are bonded together except over area 86 (to form the pocket) and in the vicinity of solder strip 88. This permits the use of a continuous solder strip in manufacture. During soldering, force is applied to all areas immediately around the pocket, which forces the solder into the window region 88 shown in phantom and seals the edges of layers 80 and 82 together.

The device used in the method shown in Figures 15 and 16 comprises a polymeric heat-stable layer 91 having an array of elongate windows 93 therein a strip of solder 97 extending across the windows 93 and a temporary backing layer 95.

As shown in Figure 15 a cable 89 with stripped conductors 90 is placed on the device. The backing layer 95 may adhere to the cable, and the system is placed initially so that the windows 93 are aligned with the conductors as they emerge from the cable insulation.

As shown in Figure 16, a burnisher 92 or similar tool is stroked along the conductors in the direction of arrow A, away from the cable insulation, to align the misaligned conductors. Downward pressure is also applied to cause the wires to move in the direction of arrow B and enter the windows 93, thus aligning them. Pressure may then be applied to the assembly to cause good adhesion of the aligned components, and alignment should thus be retained until soldering, thus preventing deformation of individual wires within the cable during handling, etc.

Figure 17 depicts another embodiment of this invention which also facilitates conductor alignment. If the backing layer 95 is placed so as to expose window 93 to the back via a small aperture 94 (or if the backing layer has suitable perforations), a hole for each wire is created. The misaligned wires may be straightened with a comb-like device 96 and the tips of the conductors 90 threaded through the apertures 94. The comb may then be removed and the cable 89 bent in the direction of arrow produce afford the arrangement of Figure 27. If desired, before soldering occurs the cable may be pulled back (once the assembly is emplaced against the termination substrate) to leave no protruding conductor ends.

An additional feature of the window means of the invention is that they may keep conductors aligned during actual soldering. In particular, when soldering a multiplicity of small diameter wires to a printed wiring board, the wires may tend to fall off during application of heat and force. The windows may be further configured to minimize this tendency.

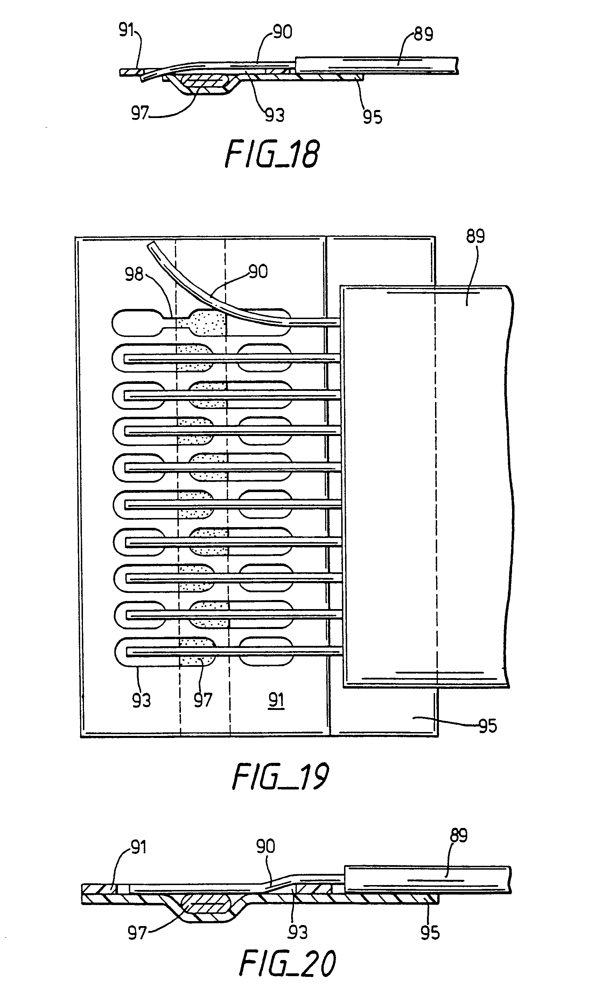

Maintenance of conductor alignment is shown in Figures 19 and 20 by one of many possible window shape variations. The windows 93 in window layer 91 have localized areas of restricted width ("grips") 98 on the precise locations desired which provide the positioning elements. The window layer portions adjacent to each end of the windows provide structural rigidity and location accuracy for every conductor. In the case shown, the grip width is an interference fit to the diameter of the conductors 90, and partly overlays the solder strip 97, shown shaded. In such a case, the grips are preferably staggered so that the potential growth incurred when the conductors are forced into place may be absorbed by simple bending of the window frames. The balance of the window remains wide enough to permit formation of a good solder fillet along the remaining conductor length, and the solder is placed to correctly guide the flow into each window. Figure 20 illustrates this in side view.

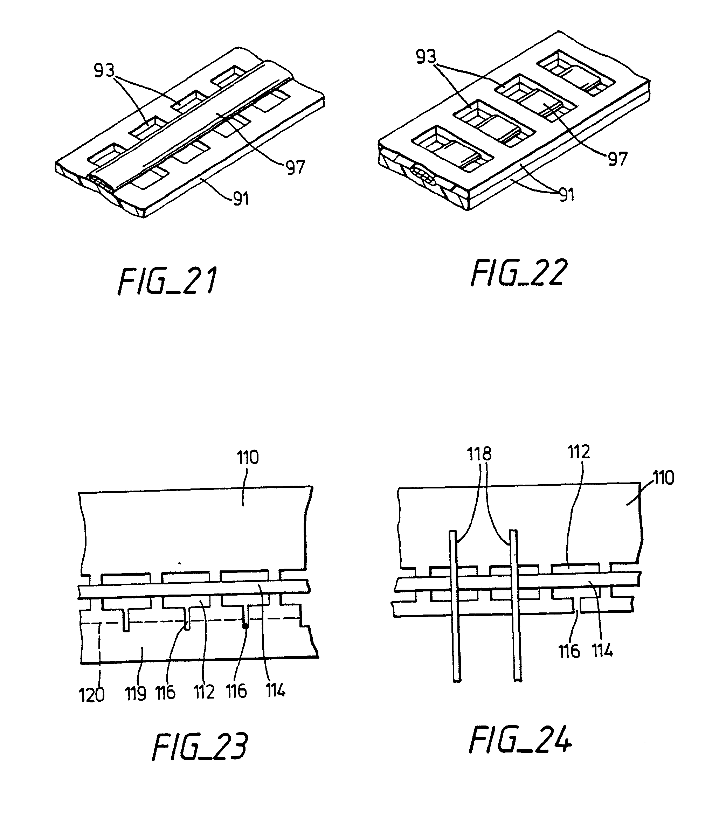

Two further forms of device suitable for the method of the invention are shown in Figures 21 and 22. In these forms of device a solder strip 95 is either, as shown in Figure 21, placed on the heat stable layer 91 over the windows 93 or, as shown in Figure 22, the solder strip is sandwiched between two layers which together form a heat stable layer and have aligned windows herein. These forms of device may for example be used by placing a flat cable on the device so that the conductors extend through the windows 93, positioning the device on the substrate e.g. a printed circuit board, and he printed circuit board, and heating the device to melt the solder strip 97.

Another device is shown in Figures 23 and 24 in which a heat stable polymeric layer 110 has a number of windows 112 each of which is formed with a narrow portion or neck 116 for gripping a conductor, the neck constituting a positioning element. The polymeric layer is placed over the substrate so that the windows 112 are in register with conductive regions of the substrate. The underside of the layer 110 is preferably adhesive in nature so that it will adhere to the substrate. The layer 110 has a tear-off portion 119 which is then separated from the remainder of the layer along a line of weakness 120, e.g. a score-line or a line of perforations, and conductors 118 are then placed over the layer 110 so that they are gripped by the necks 116 of the windows and thereby held in alignment as shown in Figure 24. The device may then be heated to fuse the solder strip 114 and form a connection between the conductors 118 and the conductive regions of the underlying substrate. Advantageously, the upper surface of the layer 110 is also adhesive in nature to assist in holding the conductors 118 in place.

Whilst the device preferably is formed with a tear-off strip 119, it is also possible to form the device initially as shown in Figure 24.

## Claims

1. A device for electrically connecting at least one first conductor to at least one second conductor, which comprises a dimensionally heat stable polymeric layer having at least one window therein, at least one strip of fusible electrically conductive material disposed with respect to the window or windows to allow the conductive material to flow through the or each window and to form a conductive connection between conductors positioned on opposite sides of the polymeric layer, and, in addition to the window or windows, one or more hollow positioning elements defined at least partly by the polymeric layer capable of receiving the or each first conductor and retaining the or each first conductor in position in the device.

2. A device for electrically connecting at least one first conductor to at least one second conductor, which comprises a dimensionally heat stable polymeric layer having at least one window therein, at least one strip of fusible electrically conductive material disposed with respect to the window or windows to allow the conductive material to flow through the or each window to form a conductive connection between conductors positioned on opposite sides of the polymeric layer, the window or windows forming one or more hollow positioning elements, the or each window being shaped to provide a portion capable of gripping a first conductor, to receive and retain the or each first conductor in the device.

3. A device as claimed in Claim 1 or Claim 2 for electrically connecting electrical conductors of a set of first conductors to electrical conductors of a set of second conductors, the device comprising a plurality of windows and a plurality of hollow positioning elements.

4. A device as claimed in any one of Claims 1 to 3, wherein the electrically conductive material comprises solder.

5. A device as claimed in any one of Claims 1 to 4, which includes a further polymeric layer that is bonded to the heat-stable polymeric layer to form at least one pocket which contains the or at least one of the windows and which constitutes a hollow positioning element.

6. A device as claimed in Claim 5, wherein the or at least part of the electrically conductive material is disposed between the heat-stable layer and the further polymeric layer.

7. A device as claimed in Claim 5 or Claim 6, wherein the said further polymeric layer is dimensionally heat-recoverable so as to grip the or each first conductor when heated.

8. A device as claimed in any one of Claims 5 to 7, wherein the or each pocket contains a plurality of windows, each of the plurality of windows having a strip of electrically conductive material associated therewith to enable the device to connect multi-conductor wires.

9. A device as claimed in any one of Claims 5 to 8, which has a plurality of the pockets.

10. A device as claimed in Claim 1 or any one of Claims 3 to 9, wherein the or each window has a generally rectangular configuration.

11. A device as claimed in Claim 2, wherein the said portion is capable of gripping the conductor by an interference fit between the portion and the conductor.

12. A device as claimed in Claim 2 or Claim 11, wherein the said portion of the or each window is in the form of a neck in which a conductor may be gripped without the conductor extending through the window.

13. A device as claimed in any one of Claims 1 to 12, wherein the heat-stable polymeric layer and/or the further polymeric layer, if present, has adhesive character.

14. A device as claimed in any one of Claims 1 to 13, which includes a temporary backing layer located on the heat-stable polymeric layer, which backing layer is capable of being removed after the or each first conductor has been positioned in the device.

15. A method of electrically connecting at least one first conductor to at least one second conductor by means of a device comprising a dimensionally heat-stable polymeric layer having at least one window therein and at least one strip of fusible electrically conductive material disposed with respect to the window or windows to allow the conductive material to flow through the or each window when heated, the device including one or more hollow positioning elements defined at least partly by the polymeric layer for receiving the or each first conductor and retaining the or each first conductor in position in the device, which method comprises positioning the or each first conductor on one side of the heat-stable polymeric layer so that the or each first conductor is received by a positioning element, positioning the or each second conductor on the opposite side of the heat-stable polymeric layer so that at least one first conductor and at least one second conductor are in register with at least one window, and heating the device to melt the electrically conductive material so that the electrically conductive material forms a conductive connection between the first and second conductor.

16. A method as claimed in Claim 15, wherein the device includes a temporary backing layer located on the heat-stable polymeric layer, the method including the step of removing the backing layer after the or each first conductor has been positioned in the device and before the or each second conductor has been positioned on the opposite side of the polymeric layer.

17. A method as claimed in Claim 15 or Claim 16, wherein the or at least one positioning element is provided by a window in the heat-stable polymeric layer, which method includes the step of burnishing the or at least one first conductor to force it into the window.

18. A method as claimed in Claim 17, wherein the or each first conductor is aligned with the device by the burnishing step.

### Patentansprüche

1. Anordnung zum elektrischen Verbinden wenigstens eines ersten Leiters mit wenigstens einem zweiten Leiter, die eine dimensionsmäßig wärmestabile polymere Schicht aufweist, die wenigstens ein Fenster darin hat, wenigstens einen Streifen aus schmelzbarem elektrisch leitendem Material aufweist, der bezüglich des Fensters oder der Fenster derart angeordnet ist, daß das leitende Material durch das oder jedes Fenster fließen kann und eine leitende Verbindung zwischen den Leitern bilden kann, die auf gegenüberliegenden Seiten der polymeren Schicht angeordnet sind, und die zusätzlich zu dem Fenster oder den Fenstern ein oder mehrere hohle Positionierelemente aufweist, die wenigstens teilweise durch die polymere Schicht gebildet werden, und die den oder jeden ersten Leiter aufnehmen und den oder jeden ersten Leiter in seiner Position in der Anordnung halten können.

2. Anordnung zum elektrischen Verbinden wenigstens eines ersten Leiters mit wenigstens einem zweiten Leiter, die eine dimensionsmäßig wärmestabile, polymere Schicht, die wenigstens ein Fenster darin hat, und wenigstens einen Streifen aus schmelzbarem, elektrisch leitendem Material aufweist, der bezüglich des Fensters oder der Fenster derart angeordnet ist, daß das leitende Material durch das oder jedes Fenster fließen kann, um eine leitende Verbindung zwischen den auf gegenüberliegenden Seiten der polymeren Schicht angeordneten Leitern zu bilden, wobei das oder die Fenster ein oder mehrere hohle Positionierelemente bilden, und wobei das oder jedes Fenster derart geformt ist, daß man einen Teil erhält, der einen ersten Leiter ergreifen kann, um den oder jeden ersten Leiter in der Anordnung aufzunehmen und festzuhalten.

3. Anordnung nach Anspruch 1 oder 2, zum elektrischen Verbinden von elektrischen Leitern eines ersten Leitersatzes mit elektrischen Leitern eines zweiten Leitersatzes, die eine Mehrzahl von Fenstern und eine Mehrzahl von hohlen Positionierelementen aufweist.

4. Anordnung nach einem der Ansprüche 1 bis 3, bei der das elektrisch leitende Material Lot aufweist.

5. Anordnung nach einem der Ansprüche 1 bis 4, bei der eine weitere polymere Schicht vorgesehen ist, die mit der wärmestabilen, polymeren Schicht verbunden ist, um wenigstens eine Tasche zu bilden, die das oder wenigstens eines der Fenster enthält und die ein hohles Positionierelement bildet.

6. Anordnung nach Anspruch 5, bei der das oder wenigstens ein Teil des elektrischen leitenden Materials zwischen der wärmestabilen Schicht und der weiteren polymeren Schicht angeordnet ist.

7. Anordnung nach Anspruch 5 oder 6, bei der die weitere polymere Schicht dimensionsmäßig wärmerückstellbar ist, so daß der oder jeder erste Leiter bei der Erwärmung ergriffen wird.

8. Anordnung nach einem der Ansprüche 5 bis 7, bei der die oder jede Tasche eine Mehrzahl von Fenstern enthält, und jedes der Mehrzahl von Fenstern einen damit verbundenen Streifen aus elektrisch leitendem Material hat, um zu ermöglichen, daß mit der Anordnung mehradrige Leitungen verbindbar sind.

9. Anordnung nach einem der Ansprüche 5 bis 8, die eine Mehrzahl von Taschen hat.

10. Anordnung nach Anspruch 1 oder einem der Ansprüche 3 bis 9, bei der das oder jedes Fenster eine im allgemeinen rechteckige Gestalt hat.

11. Anordnung nach Anspruch 2, bei der der Teil mit Hilfe eines Festsitzes zwischen dem Teil und dem Leiter den Leiter ergreifen kann.

12. Anordnung nach Anspruch 2 oder Anspruch 11, bei dem der Teil des oder jedes Fensters in Form eines Halses ausgebildet ist, in dem ein Leiter ergriffen werden kann, ohne daß sich der Leiter durch das Fenster erstreckt.

13. Anordnung nach einem der Ansprüche 1 bis 12, bei der die wärmestabile polymere Schicht und/oder die weitere polymere Schicht, wenn sie vorhanden ist, Klebeeigenschaft hat oder haben.

14. Anordnung nach einem der Ansprüche 1 bis 13, welche eine temporäre Trägerschicht umfaßt, die sich auf der wärmestabilen polymeren Schicht befindet, wobei die Trägerschicht nach der Positionierung des oder jedes ersten Leiters in der Anordnung entfernt werden kann.

15. Verfahren zum elektrischen Verbinden wenigstens eines ersten Leiters mit wenigstens einem zweiten Leiter mittels einer Anordnung, die eine dimensionsmäßig wärmestabile polymere

Schicht aufweist, die wenigstens ein Fenster darin hat und wenigstens einen Streifen aus schmelzbarem, elektrisch leitendem Material aufweist, der bezüglich des Fensters oder der Fenster derart angeordnet ist, daß das leitende Material durch das oder jedes Fenster bei der Erwärmung fließen kann, wobei die Anordnung ein oder mehrere hohle Positionierelemente umfaßt, die wenigstens teilweise von der polymeren Schicht gebildet werden, um den oder jeden ersten Leiter aufzunehmen und den oder jeden ersten Leiter in seiner Position in der Anordnung zu halten, bei welchem Verfahren der oder jeder erste Leiter auf einer Seite der wärmestabilen polymeren Schicht positioniert wird, so daß der oder jeder erste Leiter in seinem Positionierungselement aufgenommen ist, bei welchem der oder jeder zweite Leiter auf der gegenüberliegenden Seite der wärmestabilen polymeren Schicht so positioniert wird, daß wenigstens ein erster Leiter und wenigstens ein zweiter Leiter mit wenigstens einem Fenster fluchten und bei welchem die Anordnung erwärmt wird, um das elektrisch leitende Material zu erschmelzen, so daß das elektrisch leitende Material eine leitende Verbindung zwischen dem ersten und dem zweiten Leiter bildet.

16. Verfahren nach Anspruch 15, bei dem die Anordnung eine temporäre Trägerschicht enthält, die sich auf der wärmestabilen polymeren Schicht befindet, und bei dem das Verfahren den Schritt enthält, die Trägerschicht zu entfernen, nachdem der oder jeder erste Leiter in der Anordnung positioniert ist und bevor der oder jeder zweite Leiter auf der gegenüberliegenden Seite der polymeren Schicht angeordnet ist.

17. Verfahren nach Anspruch 15 oder 16, bei dem das oder wenigstens ein Positionierungselement durch ein Fenster in der wärmestabilen polymeren Schicht gebildet wird, welches Verfahren den Schritt enthält, den oder wenigstens einen ersten Leiter zu polieren, um ihn in das Fenster zu drücken.

18. Verfahren nach Anspruch 17, bei dem der oder jeder erste Leiter mit der Anordnung durch den Polierschritt ausgerichtet wird.

**Revendications**

1. Dispositif de connexion électrique d'au moins un premier conducteur sur au moins un second conducteur, qui comporte une couche polymère dimensionnellement stable à chaud, avec au moins une fenêtre, au moins une bande de matière fusible, conductrice de l'électricité, disposée par rapport à la fenêtre ou aux fenêtres de manière à permettre que la matière conductrice s'écoule par la ou chaque fenêtre et forme une connexion électrique entre des conducteurs positionnés sur des côtés opposés de la couche polymère et en plus de la ou des fenêtres, un ou plusieurs éléments de positionnement creux définis au moins partiellement par la couche polymère, pouvant recevoir le ou chaque premier conducteur et le retenant en position dans le dispositif.

2. Dispositif de connexion d'au moins un premier conducteur sur au moins un second conducteur qui comporte une couche polymère dimensionnellement stable à chaud avec au moins une fenêtre, au moins une bande de matière fusible, conductrice de l'électricité, disposée par rapport à la fenêtre ou aux fenêtres de manière à permettre que la matière conductrice s'écoule par la ou chaque fenêtre pour former une connexion conductrice entre des conducteurs positionnés sur des côtés opposés de la couche polymère, la fenêtre ou les fenêtres formant un ou plusieurs élément de positionnement creux, la ou chaque fenêtre ayant une forme qui présente une partie capable de serrer un premier conducteur, de recevoir et de retenir le ou chaque premier conducteur dans le dispositif.

3. Dispositif selon la revendication 1 ou la revendication 2, destiné à connecter électriquement des conducteurs électriques d'un groupe de premiers conducteurs à des conducteurs électriques d'un groupe de seconds conducteurs, le dispositif comportant plusieurs fenêtres et plusieurs éléments de positionnement creux.

4. Dispositif selon l'une quelconque des revendications 1 à 3, dans lequel la matière conductrice de l'électricité consiste en de la soudure.

5. Dispositif selon l'une quelconque des revendications 1 à 4, comportant une autre couche polymère qui est collée sur la couche polymère stable à chaud pour former au moins une poche qui contient la ou au moins une fenêtre et qui constitue un élément de positionnement creux.

6. Dispositif selon la revendication 5, dans lequel la ou au moins une partie de la matière conductrice de l'électricité est disposée entre la couche stable à chaud et l'autre couche polymère.

7. Dispositif selon la revendication 5 ou la revendication 6, dans lequel ladite autre couche polymère est rétractable dimensionnellement à chaud de manière à serrer le ou chaque premier conducteur lorsqu'elle est chauffée.

8. Dispositif selon l'une quelconque des revendications 5 à 7, dans lequel la ou chaque poche contient plusieurs fenêtres, chacune des plusieurs fenêtres étant associée avec une bande de matière conductrice de l'électricité pour permettre que le dispositif connecte des fils à conducteurs multiples.

9. Dispositif selon l'une quelconque des revendications 5 à 8, comprenant plusieurs poches.

10. Dispositif selon la revendication 1 ou l'une quelconque des revendications 3 à 9, dans lequel la ou chaque fenêtre a une forme générale rectangulaire.

11. Dispositif selon la revendication 2, dans lequel ladite partie peut serrer le conducteur par un ajustement serré entre la partie et le conducteur.

12. Dispositif selon la revendication 2 ou la revendication 11, dans lequel ladite partie de la ou de chaque fenêtre a la forme d'un étranglement dans lequel un conducteur peut être serré sans que le conducteur passe par la fenêtre.

13. Dispositif selon l'une quelconque des revendications 1 à 12, dans lequel la couche polymère stable à chaud et/ou l'autre couche polymère, si elle est présente, a un caractère adhésif.

14. Dispositif selon l'une quelconque des revendications 1 à 13, comportant une couche de base temporaire disposée sur la couche polymère stable à chaud, ladite couche de base pouvant être enlevée après que le ou chaque premier conducteur a été positionné dans le dispositif.

15. Procédé de connexion électrique d'au moins un premier conducteur sur au moins un second conducteur au moyen d'un dispositif comportant une couche polymère dimensionnellement stable à chaud avec au moins une fenêtre et au moins une bande d'une matière fusible, conductrice de l'électricité, disposée par rapport à la fenêtre ou aux fenêtres pour permettre que la matière conductrice s'écoule par la ou chaque fenêtre lorsqu'elle est chauffée, le dispositif comprenant un ou plusieurs éléments de positionnement creux définis au moins partiellement par la couche polymère pour recevoir le ou chaque premier conducteur et le maintenir en position dans le dispositif, le procédé consistant à positionner le ou chaque premier conducteur sur un côté de la couche polymère stable à chaud de manière que le ou chaque premier conducteur soit reçu par un élément de positionnement, à positionner le ou chaque second conducteur sur le côté opposé de la couche polymère stable à chaud de manière qu'au moins un premier conducteur et au moins un second conducteur soient alignés avec au moins une fenêtre, et à chauffer le dispositif pour fondre la matière conductrice de l'électricité de manière qu'elle forme une connexion conductrice entre le premier et le second conducteurs.

16. Procédé selon la revendication 15, dans lequel le dispositif comporte une couche de base temporaire disposée sur la couche polymère stable à chaud, le procédé consistant également à enlever la couche de base après que le ou chaque premier conducteur a été positionné dans le dispositif et avant que le ou chaque second conducteur soit positionné sur le côté opposé de la couche polymère.

17. Procédé selon la revendication 15 ou la revendication 16, dans lequel le ou au moins un élément de positionnement est formé par une fenêtre dans la couche polymère stable à chaud, le procédé consistant également à effectuer un brunissage du ou d'au moins un premier conducteur pour le forcer dans la fenêtre.

18. Procédé selon la revendication 17, dans lequel le ou chaque premier conducteur est aligné avec le dispositif par l'opération de brunissage.

FIG_1

FIG_2

FIG_3

**FIG_4**

**FIG_5**

**FIG_6**

**FIG_7**

FIG_8

FIG_9

FIG_10

FIG_11

FIG_12

FIG_13

FIG_14

FIG_15

FIG_16

FIG_17

5

91 90 89

97 93 95

## FIG_18

89

98 90

93 97 91

95

## FIG_19

91 90 89

97 93 95

## FIG_20

FIG_21

FIG_22

FIG_23

FIG_24